# EUROPÄISCHE PATENTSCHRIFT

(11) **EP 1 476 623 B1**
(45) Veröffentlichungstag und Bekanntmachung des Hinweises auf die Patenterteilung: **22.11.2006**
(21) Anmeldenummer: 03701428.9
(22) Anmeldetag: 17.02.2003
(51) Int. Cl.: E05B 65/20, E05B 17/22

(54) **ELEKTRONISCHE STEUERSCHALTUNG MIT EINEM BERÜHRUNGSSENSOR FÜR EIN FAHRZEUGTÜR-SCHLIESSSYSTEM**
ELECTRONIC CONTROL CIRCUIT COMPRISING A CONTACT SENSOR FOR A VEHICLE-DOOR LOCKING SYSTEM
CIRCUIT DE COMMANDE ELECTRONIQUE DOTE D'UN CAPTEUR DE CONTACT DESTINE A UN SYSTEME DE FERMETURE D'UNE PORTIERE DE VEHICULE

(30) Priorität: 22.02.2002 CH 3122002
(43) Veröffentlichungstag der Anmeldung: 17.11.2004
(73) Patentinhaber: SCHAFFNER EMV AG, 4542 Luterbach (CH)
(72) Erfinder: SCHNEIDER, Karl-Heinz, 72628 Rottweil (DE); ZIMPFER, Thomas, Amphur San Kampaeng, 50130 Chiang Mai (TH)
(74) Vertreter: P&TS Patents & Technology Surveys SA
(86) Internationale Anmeldenummer: PCT/CH2003/000116
(87) Internationale Veröffentlichungsnummer: WO 2003/071069

(56) Entgegenhaltungen:
- EP-A- 0 943 764
- EP-A- 0 954 098
- WO-A-01/40607
- WO-A-97/41322
- WO-A-99/19585
- US-A1- 2001 026 244

## Beschreibung

Die vorliegende Erfindung betrifft eine elektronische Steuerschaltung für ein Autotür-Schliesssystem und einen Autotür-Ziehhandgriff mit einem solchen System. Die vorliegende Erfindung betrifft auch einen Autotür-Ziehhandgriff, mit einem Hohlraum, in welchem eine elektronische Steuerschaltung untergebracht ist.

Bei solchen Autotür-Schliesssystemen wird mittels einer im Autotür-Ziehhandgriff integrierten elektronischen Steuerschaltung ein Autotür-Schliesssystem entsichert, das heisst von einem Zustand der eine Öffnung der Tür oder Klappe verhindert in einen Zustand der eine Öffnung der Tür oder Klappe ermöglicht überführt.

Bei Schliesssystemen der oben genannten Art ist schon bekannt, einer Person Zutritt zu einem Auto über eine Datenabfrage eines kontaktlosen tragbaren Datenträgers (zum Beispiel in einer Chipkarte oder in einem Schlüsselhänger) zu ermöglichen. Die Datenabfrage wird durch ein mechanisches Schaltelement ausgelöst, oder durch einen Annäherungssensor, der die Weiterleitung einer Datenabfrage an den externen tragbaren Datenträger auslöst, wenn sich eine Person dem Handgriff nähert. Der Datenträger (zum Beispiel ein Transponder) wird durch die empfangene Datenabfrage "geweckt" und beantwortet sie, indem er eine Identifizierungsmeldung an die Steuerschaltung sendet. Erst im Falle einer gültigen Identifizierung löst die Steuerschaltung die Entsicherung der Tür aus.

Annäherungssensoren, die ein infrarotes- oder Ultraschall-Sensorsystem verwenden, sind bekannt. Sie haben den Nachteil, sehr empfindlich auf Verschmutzungen oder externe Störgeräusche zu reagieren. Es wurden auch schon Mikroschalter und Drucksensoren verwendet, die jedoch erst spät (wenn der Benutzer den Handgriff tatsächlich berührt) reagieren. Diese verzögerte Datenabfrage sowie die anschliessende Reaktionszeit des Entsicherungsmechanismus machen solche Systeme unkomfortabel. In manchen Fällen hat dies zur Folge, dass das Schliesssystem bei der ersten Betätigung des Handgriffs noch nicht entsichert ist und die den Zutritt begehrende Person den Handgriff erneut berühren muss, um die Tür zu entsichern.

WO9741322 beschreibt ein System, in welchem in den Handgriffen mindestens eine Elektrode installiert ist und in dem dem Handgriff gegenüberliegenden Teil der Türe eine Gegenelektrode angebracht ist. Zwischen beiden Elektroden wird ein elektrisches Feld aufgebaut, das dazu benutzt wird, bereits den Zutrittswunsch einer nach einem Handgriff greifenden Person zu ermitteln. Sobald sich eine Hand zwischen dem Handgriff und dem gegenüberliegenden Teil der Türe befindet, wird die Sendung einer Datenabfrage an den externen Datenträger ausgelöst. Um die Datenabfrage zu senden, wird in diesem System ein elektromagnetischer Sender-Empfänger mit einer Induktionsspule verwendet. Die Annäherungssensorelektroden werden durch die Induktionsspule und/oder durch die chromplattierte Abdeckung der Handgriffe gebildet.

Es sind auch Systeme bekannt, in denen kapazitiv wirkende Annäherungssensoren verwendet werden, um den Zutrittswunsch einer nach einem Handgriff greifenden Person schon vor dem Kontakt zwischen der Hand und dem Handgriff zu sensieren. Solche Systeme messen die Kapazität zwischen einer Elektrode im Handgriff und der Erde. Nähert sich eine Person der Elektrode, wird diese Kapazität geändert, was ein Signal auslösen kann, um eine Datenabfrage zu senden.

Annäherungssensoren haben aber alle den Nachteil, ungenügend robust zu sein. Insbesondere die Zuverlässigkeit der Handsensierung ist vom Zustand der Näherungssensorelektroden abhängig. Schmutz, Wasser, Kratzer oder Beulen beeinträchtigen die Messung der Kapazität. In manchen Fällen hat dies zur Folge, dass sich annähernde Hände gar nicht, oder erst nach mehreren Versuchen sensiert werden. Es wurde auch im Rahmen dieser Erfindung festgestellt, dass die Näherungssensorelektroden durch die Induktionsspule gestört werden und dass die Kapazität nicht genau gemessen wird, wenn eine Datenabfrage gesendet wird.

Es ist somit ein Ziel der Erfindung, einen zusätzlichen Mechanismus vorzusehen, um Datenabfragen bei ankommenden Personen oder die Verriegelung des Schliesssystems nach dem Verlassen des Fahrzeugs zuverlässig auszulösen.

WO9741322 beschreibt ein Schliesssystem für Fahrzeuge mit einem als kapazitiven Sensor ausgebildeten Annäherungssensor und einem zusätzlichen mechanischen Tastschalter, der für die Verriegelung des Schliesssystems verwendet wird. Mechanische Tastschalter sind aber teuer und unzuverlässig. Ausserdem ist dieses System, welches ein aktives Betätigen des Tastschalters durch den Fahrer benötigt, nicht besonders benutzerfreundlich.

Ein anderes Ziel der vorliegenden Erfindung ist es, ein Schliesssystem anzubieten, das zuverlässiger und billiger ist als herkömmliche mechanische Schliesssysteme.

Diese Ziele und andere vorteilhafte Eigenschaften, ergeben sich aus einer elektronischen Steuerschaltung gemäss den Ansprüchen. Insbesondere werden diese Probleme durch eine mindestens teilweise auf einer Leiterplatte aufgebaute elektronische Steuerschaltung für ein Autotür-Schliesssystem, mit einer Steuereinheit mit mindestens einer Induktionsspule um eine Datenabfrage an einen externen kontaktlosen Datenträger weiterzuleiten und um die Entsicherung des Autotür-Schliesssystems auszulösen, wenn vom benannten Datenträger eine gültige Antwort empfangen wird, und mit einem Annäherungssensor, um die Annäherung einer Hand des Benutzers bereits vor dem Kontakt wahrzunehmen. Die benannte Steuereinheit und der benannte Annäherungssensor sind so gestaltet, dass sie im Aussentür-Handgriff eines Autos untergebracht werden können. Um den Kontakt zwischen der Hand einer den Zutritt begehrenden Person und dem benannten Aussentür-Handgriff wahrzunehmen, umfasst die Steuerschaltung ausserdem einen kapazitiven Berührungssensor, der zwei kapazitive Elektroden umfasst, die einander gegenüberliegend auf beiden Seiten der benannten Leiterplatte montiert sind.

Dies hat den Vorteil, dass eine Person in der Nähe des Fahrzeugs sehr früh durch den Annäherungssensor und auf jeden Fall durch den Berührungssensor (wenn sie den Handgriff in der Hand nimmt) sensiert wird. Dadurch wird das Risiko, dass den Zutritt begehrende Personen nicht wahrgenommen werden, erheblich reduziert. Ausserdem werden Personen, die das Fahrzeug verlassen, zuverlässig und ohne Manipulation eines mechanischen Tasters erfasst, sobald sie den Türgriff ergreifen, um die Tür zu schliessen.

Dies hat auch den Vorteil, dass die Empfindlichkeit des Annäherungssensors reduziert werden kann, um die Auslösung von unerwünschten stromverbrauchenden Datenabfragen zu vermeiden, da der Fahrer spätestens beim Ergreifen des Handgriffs zuverlässig sensiert wird.

Im folgenden werden anhand der beigefügten Zeichnungen bevorzugte Ausführungsbeispiele der Erfindung näher beschrieben. Es zeigen:
Fig. 1 die Handhabe eines Ziehhandgriffs und einen Teil einer Fahrzeugtür im Querschnitt
Fig. 2 die perspektivisch dargestellte Steuerschaltung
Fig. 3 das perspektivisch dargestellte Endteil der Leiterplatte mit dem Berührungssensor
Fig. 4 ein Block-Schema der Steuereinheit
Fig. 5 ein Schema des Berührungssensor-Kapazitätsmesssystems

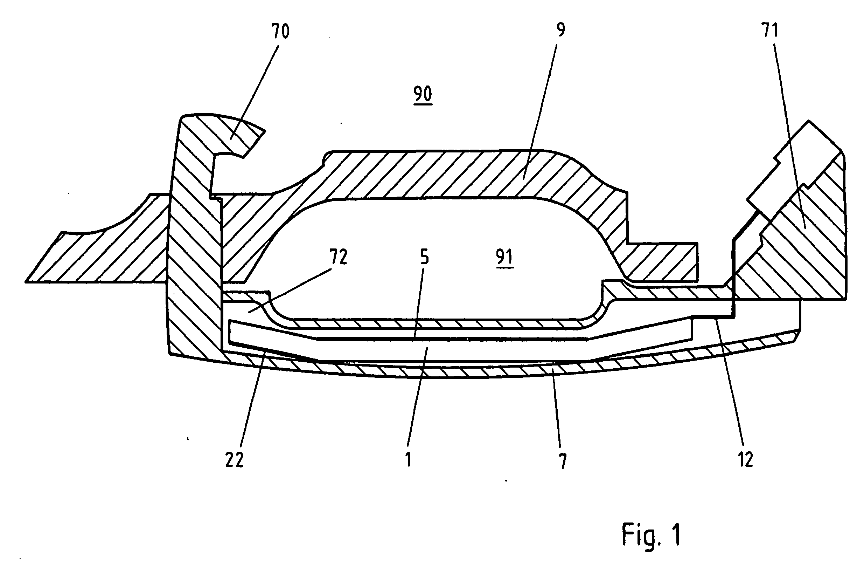

In der Figur 1 ist mit 7 ein Fahrzeugtür-Ziehhandgriff dargestellt, welcher einen an der Fahrzeugtür befestigten Innenteil 9 und eine als Bügelgriff ausgebildete Handhabe 7 umfasst. Die Handhabe 7 umfasst einen Griffdom 70, der mit dem der Handhabe 7 abgewandten Ende in den Innenraum 90 der Fahrzeugtür ragt und mit dem aus Übersichtlichkeitsgründen nicht dargestellten Autotür-Schliesssystem verbunden ist. Das Autotür-Schliesssystem wird über das Fahrzeug-Zentralverriegelungssystem entsichert, um den Griffdom 70 und somit die Handhabe 7 zu befreien. Im befreiten Zustand kann die Handhabe 7 nach aussen gezogen werden um die Fahrzeugtür zu öffnen. Zu diesem Zweck kann die Handhabe 7 um das dargestellte Gelenk 71 gedreht werden. Als Variante könnte die Tür nach der Erkennung einer gültigen Identifizierung der den Zutritt begehrenden Person automatisch aufspringen.

In der Handhabe 7 befindet sich ein Hohlraum 72, in welchem die elektronische Steuerschaltung 1 untergebracht ist, die dem berechtigten Benutzer auf möglichst komfortable Weise die Auslösung der Entsicherung des Autotür-Schliesssystems ermöglichen soll. Die Steuerschaltung 1 wird durch Verbindungskabel 12 mit dem Autotür-Schliesssystem im Innern des Fahrzeugs verbunden. Sie wird vorzugsweise über diese Verbindungskabel von der Autobatterie mit Strom versorgt. Im Falle eines Stromausfalls kann die Tür vorzugsweise mittels eines nicht dargestellten Schliesszylinders mit einem für solche Fälle vorgesehenen Schlüssel geöffnet werden.

Die Steuerschaltung umfasst einen Berührungssensor 22, der ein Signal auslöst sobald der Benutzer einen Finger (insbesondere einen Daumen) auf die äussere Seite der Handhabe legt. Ein Annäherungssensor löst ein anderes Signal aus wenn sich eine Hand nähert, insbesondere im Falle der Annäherung einer Hand oder eines anderen geerdeten Objekts an den Zwischenraum zwischen Handhabe 7 und dem Innenteil des Handgriffs 9. Wie später erläutert, werden diese Signale von einer Steuereinheit 20 mit einem Mikrokontroller 23 und mindestens einer Induktionsspule 3 interpretiert, um eine Datenabfrage an einen nicht dargestellten externen kontaktlosen Datenträger weiterzuleiten.

Der Datenträger besteht vorzugsweise aus einem Transponder (der beispielsweise in eine Chipkarte oder in einen Schlüsselhänger integriert werden kann) und wird durch diese Datenabfrage "geweckt". Wenn die Datenabfrage an ihn gerichtet ist, reagiert er mit einer Antwort, die eine Identifizierung des Datenträgers beinhaltet oder die mit einer solchen Identifizierung signiert wird. Die Antwort wird von der elektronischen Steuereinheit 20 in der Handhabe 7 empfangen, um die Entsicherung des Autotür-Schliesssystems auszulösen, wenn sie die erwartete Identifizierung enthält bzw. wenn sie mit dieser erwarteten Identifizierung signiert wurde.

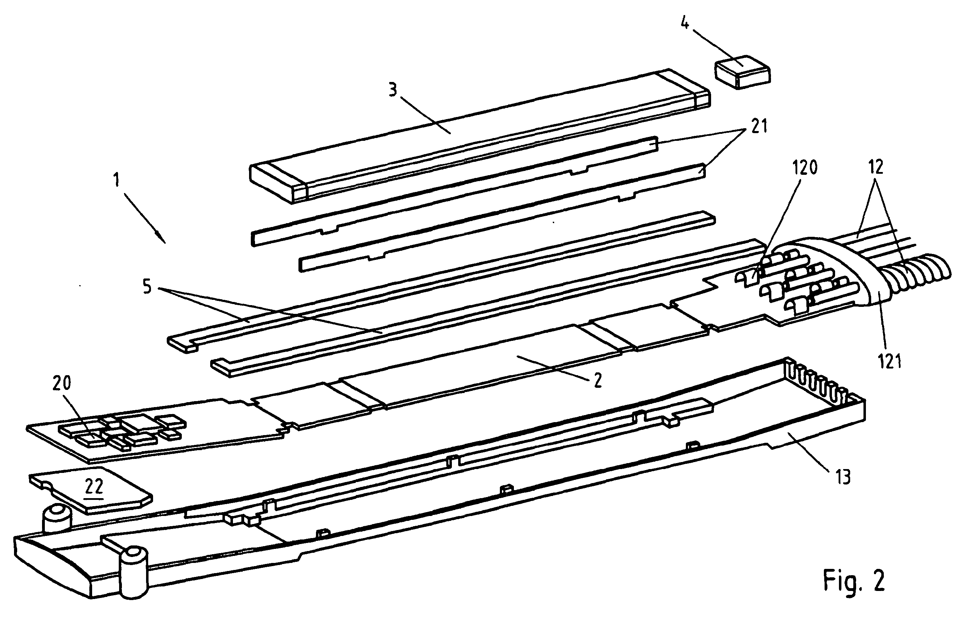

Die Steuerschaltung 1 wird in Zusammenhang mit der Figur 2 näher beschrieben. Sie umfasst eine Leiterplatte 2, auf welcher alle Bauteile 20, 21, 22, 3, 4, 5, 120 montiert sind. Die Leiterplatte 2 hat vorzugsweise eine Dicke von 0.2 mm oder weniger und ist somit flexibel und weniger bruchanfällig. Sie wird in einem synthetischen isolierenden Gehäuse 13 untergebracht, welches longitudinal den grössten Teil des Hohlraums 72 in der Handhabe 7 ausfüllt.

Auf der linken Seite der Leiterplatte 2 ist die Steuereinheit 20 montiert, welche mehrere durch einen sogenannten Reflow Prozess montierte elektronische SMD-Bauteile, einschliesslich den Mikrokontroller 23, umfasst. Die Verbindungskabel 12 werden durch das sogenannte Autosplice Verfahren parallel zur Leiterplatte auf der rechten Seite derselben montiert. Das Autosplice Verfahren hat im Vergleich zu anderen Löt- oder Befestigungsverfahren vor allem den Vorteil, dass es wesentlich weniger empfindlich auf Stösse, Vibrationen und Temperaturänderungen reagiert. Eine synthetische Dichtung 121 (zum Beispiel aus Santoprene oder aus einem anderen Elastomer) hält die Kabel 120 an ihrem Platz fest und verhindert Feuchtigkeitsinfiltrationen in das Gehäuse.

Die Steuerschaltung 1 umfasst ausserdem einen kontaktlosen Sender-Empfänger, um Daten mit dem externen kontaktlosen Datenträger auszutauschen. In der bevorzugten dargestellten Variante umfasst der kontaktlose Sender-Empfänger eine Resonanzschaltung mit einer Induktionsspule 3 und einen Kondensator 4, die direkt auf der Leiterplatte 2 montiert sind. Die Induktionsspule besteht aus einer Wicklung eines elektrisch isolierten Drahtes auf einem plattenförmigen ferromagnetischen Ferritkern. Der Kondensator ist vorzugsweise ein Keramik- oder Polypropylene-Kondensator mit einer Kapazität von ca. 15 bis 18nF. Sie dient zur Impedanzanpassung des Sender-Empfängers an die Treiberstufe des Mikrokontrollers. Die Steuerschaltung 1 umfasst ausserdem einen Annäherungssensor 25 mit in diesem bevorzugten Beispiel zwei Annäherungssensorelektroden 51, 52 (zusammen 5), um Personen die sich dem Handgriff nähern zu sensieren. Die Annäherungssensorelektroden 5 sind elektrisch derart mit der Steuereinheit 20 verbunden, dass die vom Benutzerkörper verursachten Kapazitätsänderungen zwischen den Annäherungssensorelektroden 5 und der Erde sensiert werden. Nähert sich eine (geerdete) Person den Annäherungssensorelektroden 5, wird die Kapazität zwischen diesen Elektroden und der Erde beeinträchtigt. Die Steuereinheit 20 ermittelt diese kleinen Kapazitätsänderungen vorzugsweise anhand eines Ladungsübertragungsmesssystems, d.h. indem die unbekannte Kapazität mit einer grösseren Referenzkapazität über Schalter geschaltet wird.

Zwischen der Annäherungssensorelektroden 5 und der Induktionsspule 3 ist eine elektrostatische Abschirmung 21 vorgesehen.

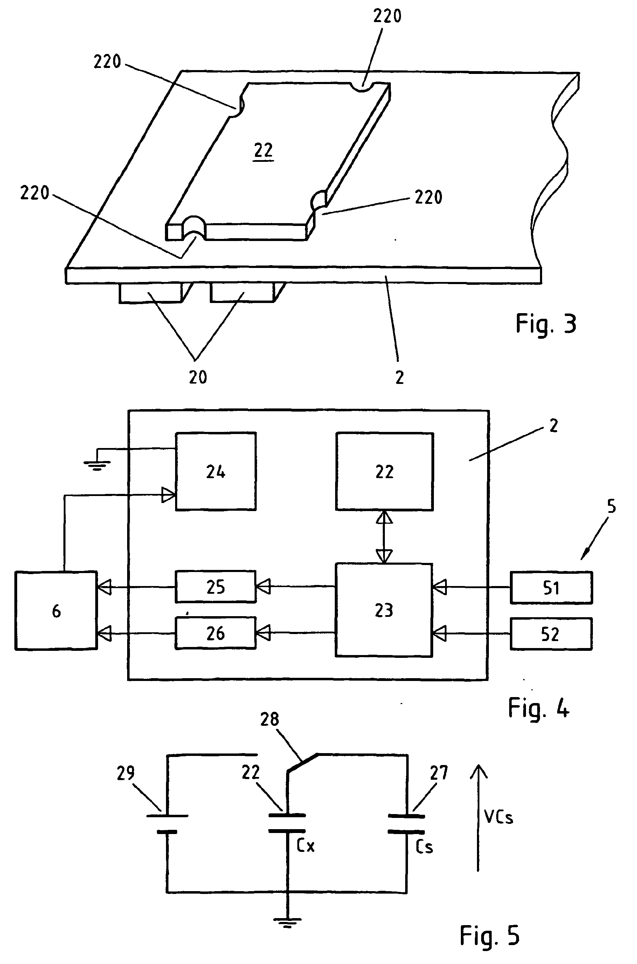

Der Berührungssensor enthält eine Kapazität mit einer Elektrode 22 auf der nach aussen gewandten Seite der Leiterplatte 2 und eine andere Elektrode auf der inneren Seite der Leiterplatte, die beispielsweise aus den Grundleitbahnen auf der bestückten Seite der Leiterplatte bestehen kann. Figur 3 zeigt die kapazitive Elektrode 22 des Berührungssensors, die auf der Leiterplatte 2 so montiert ist, dass Kontakte zwischen der Hand, insbesondere des Daumens, des im Fahrzeug Zutritt begehrenden Benutzers und der Aussenseite der Handhabe ermittelt werden können (auf dieser Figur auf der linken Seite). Die Kapazität Cx zwischen der Elektrode 22 und der Masse auf der anderen Seite der Leiterplatte ist vorzugsweise kleiner als 5pF. Diese Kapazität ändert sich wenn eine andere Masse (zum Beispiel eine Hand) in die Nähe der Elektrode 22 kommt.

Der Berührungssensor besteht aus der Kapazität 22 und dem Mikrokontroller 23, der die Kapazität zwischen der Elektrode 22 und der Masse ermittelt. Die Fläche der Elektrode 22 muss so gross wie möglich sein, um die empfindliche Zone am Handgriff (wohin der Benutzer seinen Daum legen kann) nicht zu begrenzen. In einer bevorzugten Variante beträgt diese Fläche etwa 10mm X 10mm. Damit aber die Kapazität Cx zwischen der Elektrode 22 und der Erdeleitbahn auf der anderen Seite der Leiterplatte 2 klein bleibt, muss ein genügend grosser Abstand zwischen der Elektrode 22 und der Leiterplatte 2 vorgesehen werden. Im dargestellten Beispiel besteht die Elektrode 22 aus einem Stück einer etwa 0.2 mm dicken Leiterplatte, deren obere Fläche metallisiert ist. Die Dicke des dielektrischen Materials zwischen der Elektrode 22 und der anderen Elektrode der Kapazität Cx beträgt somit die Dicke der Leiterplatte 2 plus 0.2mm.

Metallisierte Aussparungen 220 werden am Rand der Elektrode 22 vorgesehen, um sie als SMD-Bauteil auf der Leiterplatte 2 zu montieren. Auf diese Weise kann die Distanz zwischen der Elektrode 22 und der Leitbahnen auf der anderen Seite der Leiterplatte 2 genau reproduzierbar festgestellt werden.

Diese Variante hat den Nachteil, dass die Gesamtdicke der Steuerschaltung durch die etwa 0,2mm dicke Elektrode 22 erhöht wird. Dies kann in sehr dünnen Handgriffen problematisch sein. Um die Kapazität Cx zu reduzieren ohne den Abstand zwischen der Elektrode 22 und den Erdeleitbahnen auf der anderen Seite der Leiterplatte 2 zu erhöhen und ohne die Fläche der empfindlichen Berührungszone zu reduzieren, können in einer nicht dargestellten Variante Aussparungen (zum Beispiel Löcher) in der metallisierten Fläche der Elektrode 22 vorgesehen werden. In einer bevorzugten Variante besteht die Elektrode 22 aus einem metallisierten Oberfläche mit einer Struktur von Aussparungen (zum Beispiel Raster, Streifen, Löcher, usw.) direkt auf der unteren Seite der Leiterplatte 2.

Figur 5 erklärt das Prinzip des Berührungssensor-Kapazitätsmesssystems. Die Kapazität Cx zwischen der Elektrode 22 und der Masse ändert sich, sobald eine andere Masse in die unmittelbare Nähe dieser Elektrode kommt. Die Steuereinheit 20 ermittelt diese kleinen Kapazitätsänderungen vorzugsweise anhand eines Ladungsübertragungsmesssystems, d.h. indem die unbekannte Kapazität mit einer grösseren Referenzkapazität über Schalter geschaltet wird. Der Kapazitätswert Cx wird gemessen, indem die Ladezeit einer Referenzkapazität 27 (Cs) durch die Kapazität 22 vom Mikrokontroller 23 ermittelt wird. Die Berührungssensorkapazität 22 wird zuerst durch eine Referenzspannungsquelle 29 (zum Beispiel ausgangs des Mikrokontrollers 23) geladen. Der Schalter 28 wird dann aktiviert, um die Referenzkapazität 27 durch die Berührungssensorkapazität 22 zu laden. Die Zeit die benötigt wird bis die Spannung VCs über die Referenzkapazität 27 eine vordefinierte Schwelle erreicht, wird ermittelt um den Wert Cx zu messen. Der Mikrokontroller 23 ermittelt den Zustand des Berührungssensors aufgrund von mehreren nachfolgenden Messungen dieser Zeit.

Ein ähnliches kapazitives Messprinzip kann verwendet werden, um den Zustand des Annäherungssensors 5 zu ermitteln.

Figur 4 zeigt ein Blockschema der Steuereinheit 20. Die Schaltung umfasst einen Mirokontroller 23, der über bidirektionale Ein- und Ausgänge mit dem Annäherungssensor 5 und mit dem Berührungssensor 22 verbunden ist. Der Mikrokontroller steuert diese Sensoren und bewertet die empfangenen Signale. Ein erstes digitales Signal aus dem Mikrokontroller 23 gibt den Zustand des Annäherungssensors 5 an; dieses Signal wird über eine Schnittstelle 25 an das Autotür-Schliesssystem im Innern des Fahrzeugs weitergeleitet. Der vom Mikrokontroller 23 ermittelte Zustand des Berührungssensors 22 wird als zweites digitales Signal über die Schnittstelle 26 auf ähnliche Art an das Autotür-Schliesssystem weitergeleitet. Eine programmierte oder verkabelte Logikeinheit im Schliesssystem bewertet diese Signale um zu entscheiden, wann das Schliesssystem entsichert werden muss, wann es verriegelt werden muss, und wann eine Datenabfrage über den kontaktlosen Sender-Empfänger 3, 4 an den Datenträger der den Zutritt begehrenden Person gesendet oder bewertet werden muss, um die Identität der Person zu prüfen. Die Steuereinheit 20 im Handgriff 7 umfasst noch ein Speisemodul 24, das aus den vom Fahrzeug empfangenen Spannungen die für den Mikrokontroller 23 benötigten Spannungen liefert.

Die Steuereinheit 20 und der Berührungssensor 22 sind mit der Sender-Empfängerschaltung und mit den Verbindungskabeln 12 über Leiterbahnen auf der Leiterplatte 2 verbunden. Diese Bahnen verlaufen unter der Induktionsspule 3, möglicherweise auch auf der anderen Seite der Leiterplatte und/oder durch innere Schichten.

Die Leiterplatte 2 wird in einem synthetischen Gehäuse 13 untergebracht, das sich substantiell durch die ganze Länge des Hohlraums 72 im Griffteil 7 erstreckt. Das Gehäuse 13 und die Annäherungselektroden 5 sind vorzugsweise leicht gekrümmt, um sich an die bügelige Form des Handgriffteils 7 anzupassen. Da gekrümmte Ferritkerne teuer sind und da Probleme bei der Drahtwicklung auf einem bügelformigen Kern entstehen können, sind vorzugsweise nur die beiden Enden des Gehäuses 13 gekrümmt, wie auf der Figur 2 ersichtlich.

In einer weiteren Ausführungsform ist der Kern der Spule und somit die ganze Spule 3 flexibel. Da die Leiterplatte vorzugsweise so dünn ist, dass sie auch eine gewisse Flexibilität aufweist, wird die Anpassung der Steuerschaltung an die bügelige Form des Handgriffteils 7 wesentlich vereinfacht. Ausserdem ist ein flexibler magnetischen Kern weniger brechbar als ein Ferritkern. Die Zuverlässigkeit der Steuerschaltung wird also damit wesentlich erhöht, indem ihre Empfindlichkeit an den in einer Autotür unvermeidbaren Stössen vermindert wird. Der flexible Kern besteht zum Beispiel aus mehreren dünnen flexiblen Schichten eines magnetischen Materials, die mit flexiblen Befestigungsmitteln zusammen gehalten werden. In einer weiteren Ausführungsform wird der magnetischen Kern aus einem amorphen magnetischen Material gebildet, dass heisst aus einer flexiblen Gussmasse, in der kleine Partikel eines Materials mit hoher Permeabilität wie zum Beispiel Ferritpartikel eingegossen sind. In einer noch weiteren Ausführungsform ist der magnetische Kern mehrteilig. Er besteht zum Beispiel aus mehreren kleineren Teilen aus einer möglicherweise harten magnetischen Materie wie zum Beispiel aus Ferrit, die zusammen mit einer vorzugsweise magnetischen flexiblen Materie verbunden werden.

Die Leiterplatte 2 mit allen Bauteilen wird in einem thermoplastischen isolierenden Material eingekapselt, das in den benannten Hohlraum gespritzt wird und das die Bauteile vor Feuchtigkeit und Schmutz schützt. Es kann beispielsweise ein "Hot Melt" Material (zum Beispiel Macromelt) verwendet werden, das mit einer Temperatur von ca. 215° Grad und niedrigem Druck gespritzt wird.

Da das Material gespritzt und nicht einfach umgegossen wird, kann man die Dicke des Materials genau kontrollieren und von der grösseren Dicke der Handhabe7 in der Mitte profitieren. Es ist somit auch möglich, die Dicke des Spritzmaterials über den Elektroden 22 und 5 zu reduzieren, um deren Empfindlichkeit nicht zu vermindern.

Obwohl sich die ganze Beschreibung auf einen Fahrzeug-Ziehhandgriff bezieht, wird man verstehen, dass sich diese Erfindung auch für andere Typen von Fahrzeug-Türaussengriffen eignet, insbesondere für Griffklappen.

## Patentansprüche

1. Elektronische Steuerschaltung für ein Autotür-Schliesssystem, enthaltend:
einer Leiterplatte (2) auf welcher mindestens gewisse Bauteile der benannten Steuerschaltung montiert sind,
eine Steuereinheit (20) mit mindestens einer Induktionsspule (3), um eine Datenabfrage an einen externen kontaktlosen Datenträger weiterzuleiten und um die Entsicherung des Autotür-Schliesssystems auszulösen, wenn vom benannten Datenträger eine gültige Antwort empfangen wird,
einen Annäherungssensor (5), um die Annäherung einer Hand des Benutzers bereits vor dem Kontakt wahrzunehmen,
wobei die benannte Steuereinheit (20) und der benannte Annäherungssensor (5) so gestaltet sind, dass sie im Aussentür-Handgriff eines Autos (7) untergebracht werden können,
**gekennzeichnet durch** einen kapazitiven Berührungssensor (22), um den Kontakt zwischen der Hand einer Person und dem benannten Aussentür-Handgriff (7) wahrzunehmen, der zwei kapazitive Elektroden umfasst, die einander gegenüberliegend auf beiden Seiten der benannten Leiterplatte montiert sind.

2. Steuerschaltung gemäss Anspruch 1, in welcher die besagten zwei kapazitive Elektrode derart positioniert sind, dass sie den Kontakt zwischen einem Daumen der benannten Person und dem benannten Handgriff (7) wahrnehmen können.

3. Steuerschaltung gemäss einem der vorherigen Ansprüche, in welcher eine der benannten zwei Elektroden aus den Erd-Leitbahnen der benannten Steuerschaltung (20) besteht.

4. Steuerschaltung gemäss einem der vorherigen Ansprüche, in welcher die andere der benannten zwei Elektroden aus einer metallisierten Platte (22) besteht, die über die benannte Leiterplatte montiert ist.

5. Steuerschaltung gemäss Anspruch 4, in welcher die benannte Platte (22) Aussparungen (220) am Rand aufweist, um sie als SMD-Bauteil auf die benannte Leiterplatte zu montieren.

6. Steuerschaltung gemäss einem der Ansprüche 1 bis 3, in welcher die andere benannte Elektrode (22) eine Struktur von Aussparungen in einer metallisierten Oberfläche aufweist.

7. Steuerschaltung gemäss einem der vorherigen Ansprüche, in welcher die benannte Leiterplatte flexibel ist.

8. Steuerschaltung gemäss einem der vorherigen Ansprüche, in welcher die benannte Leiterplatte (2) in thermoplastisches Material eingekapselt ist.

9. Steuerschaltung gemäss Anspruch 8, die in einem Gehäuse untergebracht ist und in welcher sich die benannte Leiterplatte (2) über die ganze Länge des Gehäuses (13) erstreckt.

10. Steuerschaltung gemäss einem der vorherigen Ansprüche, in welcher die benannte Induktionsspule (3) in Serie mit einer Kapazität (4) verbunden ist, um die benannte Datenabfrage kontaktlos zu senden.

11. Steuerschaltung gemäss einem der vorherigen Ansprüche, in welcher eine elektrostatische Abschirmung (21) zwischen dem benannten Annäherungssensor und der benannten Induktionsspule vorgesehen ist.

12. Steuerschaltung gemäss einem der vorherigen Ansprüche, in welcher die Kapazität (Cx) des benannten Berührungssensors mit einem Mikrokontroller (23) erfasst wird.

13. Steuerschaltung gemäss einem der vorherigen Ansprüche, in welcher die Kapazität (Cx) des benannten Berührungssensors durch ein Ladungsübertragungsmesssystem gemessen wird.

## Claims

1. Electronic control circuit for a car-door locking system, comprising:
a printed circuit board (2) on which at least certain components of said control circuit are mounted,
a control unit (20) with at least one induction coil (3) for forwarding a data query to an external contactless data carrier and for triggering the release of the car-door locking system if a valid reply is received from said data carrier,
an approach sensor (5) for detecting the approach of a hand of the user even before contact,
wherein said control unit (20) and said approach sensor (5) are designed in such a fashion that they can be accommodated in the outer door handle of a car (7),
**characterized by** a capacitive touch sensor (22) for detecting the contact between the hand of a person and said outer door handle (7), comprising two capacitive electrodes mounted opposite each other on both sides of said printed circuit board.

2. Control circuit according to claim 1, wherein said two capacitive electrodes are positioned in such a manner that they can detect the contact between the thumb of said person and said handle (7).

3. Control circuit according to one of the preceding claims, wherein one of said two electrodes consists of an earth lead circuit of said control unit (20).

4. Control circuit according to one of the preceding claims, wherein the other of said two electrodes consists of a metallized plate (22) that is mounted over said printed circuit board.

5. Control circuit according to claim 4, wherein said plate (22) has cut-outs (220) on the edge in order for it to be mounted as surface mounted device (SMD) component on said printed circuit board.

6. Control circuit according to one of the claims 1 to 3, wherein the other said electrode (22) has a structure of cut-outs in a metallized surface.

7. Control circuit according to one of the preceding claims, wherein said printed circuit board is flexible.

8. Control circuit according to one of the preceding claims, wherein said printed circuit board (2) is encapsulated in thermoplastic material.

9. Control circuit according to claim 8, being accommodated in a housing, and wherein said printed circuit board (2) stretches over the entire length of the housing (13).

10. Control circuit according to one of the preceding claims, wherein said induction coil (3) is connected serially with a capacitance (4) in order to send contactlessly said data query.

11. Control circuit according to one of the preceding claims, wherein an electrostatic shielding (21) is provided between said approach sensor and said induction coil.

12. Control circuit according to one of the preceding claims, wherein the capacitance (Cx) of said approach sensor is recorded with a micro-controller (23).

13. Control circuit according to one of the preceding claims, wherein the capacitance (Cx) of said approach sensor is measured through a charge transfer measuring system.

## Revendications

1. Circuit de commande électronique pour un système de fermeture de portière d'auto, comprenant:
une plaquette de circuit imprimé (2) sur laquelle sont montés au moins certains composants dudit circuit de commande électronique
une unité de commande (20) avec au moins une bobine d'induction (3) pour faire suivre une requête de données à un support de données externe sans contact et pour déclencher le déverrouillage du système de fermeture de portière d'auto, lorsqu'une réponse valide est reçue dudit support de données,
un détecteur d'approche (5) pour percevoir l'approche d'une main d'utilisateur déjà avant le contact,
ladite unité de commande (20) et ledit détecteur d'approche (5) étant agencés de telle sorte qu'ils puissent être logés dans la poignée externe d'une portière d'une auto (7),
**caractérisé par** un capteur tactile capacitif(22) pour percevoir le contact entre la main d'une personne et de ladite poignée externe de portière, qui comprend deux électrodes capacitives qui sont montées l'une en face de l'autre de chaque côté de ladite plaquette à circuit imprimé.

2. Circuit de commande selon la revendication 1, dans lequel lesdites deux électrodes capacitives sont positionnées de façon à ce qu'elles puissent percevoir le contact entre le pouce de ladite personne et ladite poignée (7).

3. Circuit de commande selon l'une des revendications précédentes, dans lequel une desdites deux électrodes consiste en la masse dudit circuit de commande (20).

4. Circuit de commande selon l'une des revendications précédentes, dans lequel l'autre desdites deux électrodes consiste en une plaquette métallisée (22), qui est montée sur ladite plaquette à circuit imprimé.

5. Circuit de commande selon la revendication 4, dans lequel ladite plaquette (22) présente des échancrures (220) au bord, afin de la monter comme composant SMD sur ladite plaquette à circuit imprimé.

6. Circuit de commande selon l'une des revendications 1 à 3, dans lequel l'autre dite électrode (22) présente une structure d'évidement dans une surface supérieure métallisée.

7. Circuit de commande selon l'une des revendications précédentes, dans lequel ladite plaquette à circuit imprimé est flexible.

8. Circuit de commande selon l'une des revendications précédentes, dans lequel ladite plaquette à circuit imprimé (2) est encapsulée dans un matériel thermoplastique.

9. Circuit de commande selon la revendication 8, qui est logé dans un boîtier et dans lequel ladite plaquette à circuit imprimé (2) s'étend sur toute la longueur du boîtier (13).

10. Circuit de commande selon l'une des revendications précédentes, dans lequel ladite bobine d'induction (3) est reliée en série avec une capacité (4) pour envoyer sans contact ladite requête de données.

11. Circuit de commande selon l'une des revendications précédentes, dans lequel un blindage électrostatique (21) est prévu entre ledit détecteur d'approche et ladite bobine d'induction.

12. Circuit de commande selon l'une des revendications précédentes, dans lequel la capacité (Cx) dudit détecteur tactile est saisie avec un microcontrôleur.

13. Circuit de commande selon l'une des revendications précédentes, dans lequel la capacité (Cx) dudit détecteur tactile est mesurée par un système de mesure de transfert de charge.
